Europäisches Patentamt

European Patent Office

Office européen des brevets

(11) Publication number: **0 232 144 B1**

# EUROPEAN PATENT SPECIFICATION

(45) Date of publication of patent specification: **17.06.92** (51) Int. Cl.5: **H03M 5/14, G11B 20/14**

(21) Application number: **87300832.0**

(22) Date of filing: **30.01.87**

Divisional application 91109882.0 filed on
30/01/87.

(54) **Data demodulation system.**

(30) Priority: **31.01.86 JP 20448/86**

(43) Date of publication of application:
**12.08.87 Bulletin 87/33**

(45) Publication of the grant of the patent:
**17.06.92 Bulletin 92/25**

(84) Designated Contracting States:
**DE FR GB**

(56) References cited:
**EP-A- 0 144 813**
**WO-A-85/01402**
**US-A- 4 115 768**
**US-A- 4 538 189**

**IBM TECHNICAL DISCLOSURE BULLETIN, vol. 27, no. 7B, December 1984, pages 4274-4277, New York, US; H.J. GARDNER et al.: "Mark generation in 2,7 code"**

**PATENT ABSTRACTS OF JAPAN, vol. 8, no. 89 (P-270)[1526], 24th April 1984; & JP-A-59 3714 (DENSHI KEISANKI KIHON GIJUTSU KENKIYUU KUMIAI) 10-01-1984**

(73) Proprietor: **SHARP KABUSHIKI KAISHA**
**22-22 Nagaike-cho Abeno-ku**
**Osaka 545(JP)**

(72) Inventor: **Tsuji, Kentaroh**
**37-19-3 Shichijo 1-chome**
**Nara-shi Nara-ken(JP)**
Inventor: **Fujiwara, Tsuneo**
**Akebono-ryo 2613-1 Ichinomoto-cho**
**Tenri-shi Nara-ken(JP)**
Inventor: **Maeda, Shigemi**
**2996-18 Koizumi-cho**
**Yamatokoriyama-shi Nara-ken(JP)**
Inventor: **Yamaguchi, Takeshi**
**Akebono Ryo 2613-1 Ichinimoto-cho**
**Tenri-shi Nara-ken(JP)**
Inventor: **Deguchi, Toshihisa Daiya-Heights**
**Gakuenmae C-722**
**2-200-5 Gakuenmaeyamoto-cho**
**Nara-shi Nara-ken(JP)**
Inventor: **Kobayashi, Shozou**
**2-3-305 Sanjyokawanishi-cho**
**Nara-shi Nara-ken(JP)**

(74) Representative: **Brown, Kenneth Richard et al**
**R.G.C. Jenkins & Co. 26 Caxton Street**
**London SW1H 0RJ(GB)**

**IBM TECHNICAL DISCLOSURE BULLETIN, vol. 23, no. 4, September 1980, pages 1635-1636, New York, US; P. HODGES: "Encoding and decoding checking arrangement for 2-7 run-length limited codes"**

**IBM TECHNICAL DISCLOSURE BULLETIN, vol. 23, no. 4, September 1980, pages 1673-1675, New York, US; G.A. DUNN: "Phase setting for a (2,7) code decoder"**

**IBM TECHNICAL DISCLOSURE BULLETIN, vol. 23, no. 1, June 1980, pages 318-319, New York, US; R.E. JENKINS: "1F/2F Phase alignment system"**

# Description

This invention relates to a data demodulation system and its apparatus used in magnetic recording, optical recording, etc.

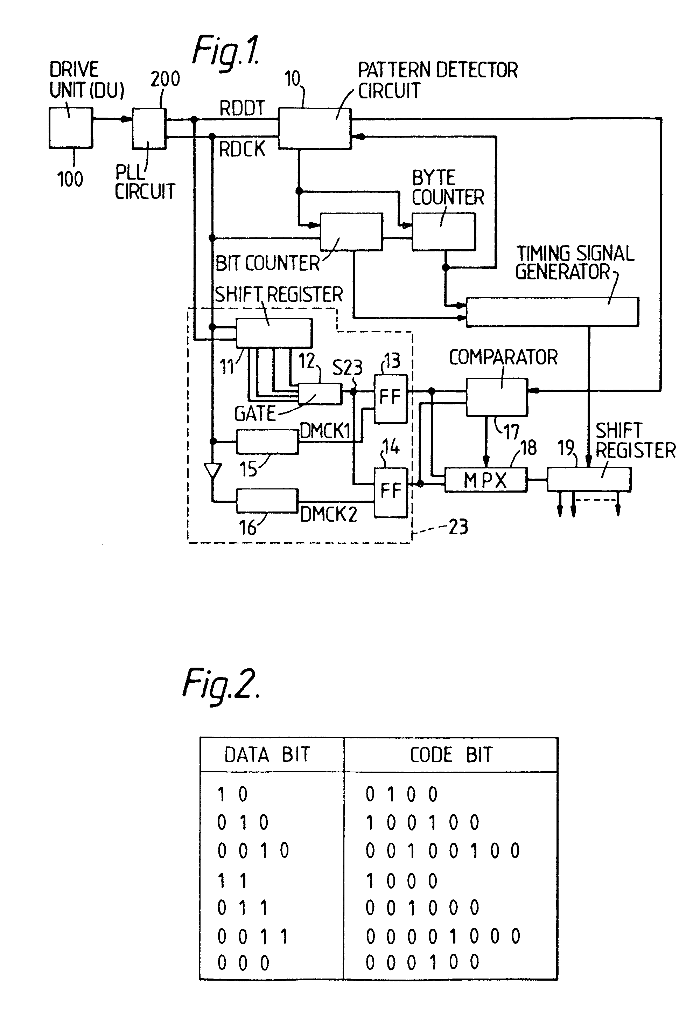

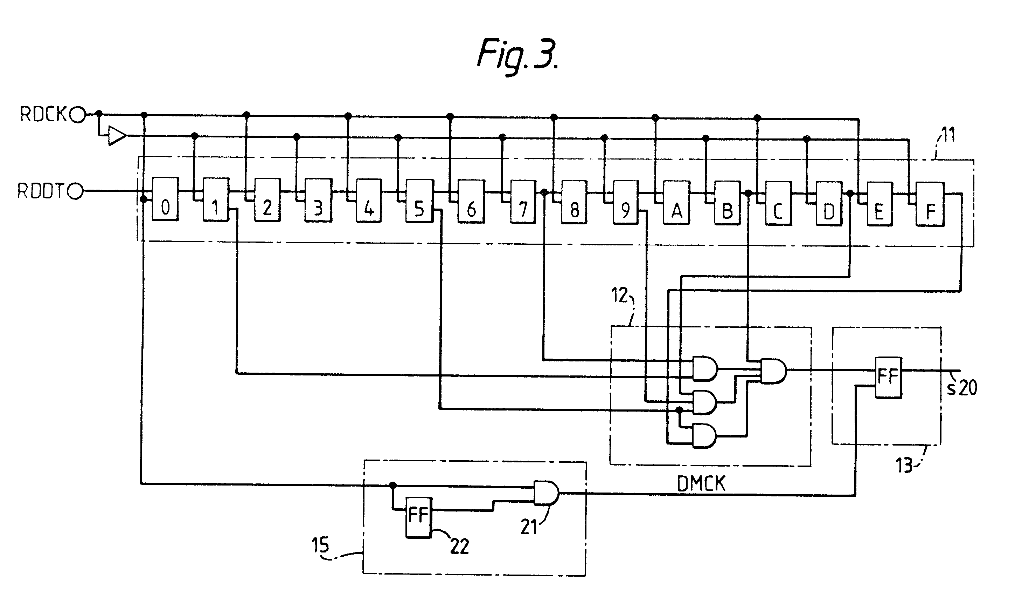

Conventionally, one known sequential coding method of constant ratio data codes of variable word length, is the 2-7 modulation/demodulation system as described in United States Patent Specification US-A-4,115,768 (the disclosure of which is included herein by way of reference). In the 2-7 modulation/demodulation system, as shown in Fig. 2, 2-bit codes are used for 1-bit data, and when demodulating, in order to convert 2-bit codes into the original 1-bit data, a demodulation clock DMCK is needed.

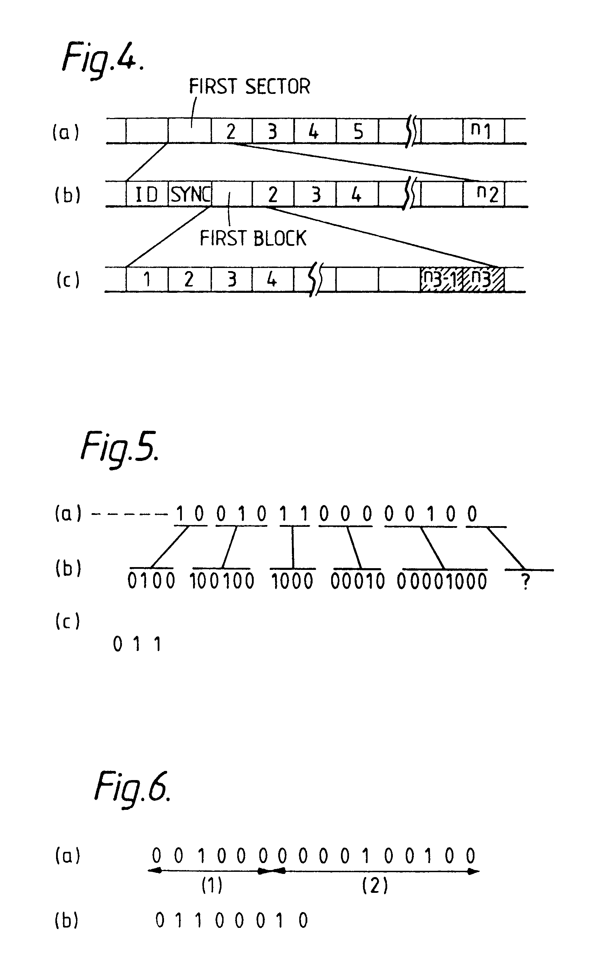

Fig. 3 refers to an example of a conventional demodulation circuit employed in the 2-7 modulation/demodulation system. In this system the read data RDDT is introduced into a shift register 11 which is operated by a read clock RDCK. The output of the shift register 11 is introduced into a logic gate circuit 12, and this output is synchronized by the 1/2 period read clock RDCK introduced into a demodulation clock generator circuit 13, that is, a demodulation clock DMCK, thereby obtaining demodulated data S20.

Thus, in the conventional circuit, since the demodulation clock DMCK is obtained by compressing the read clock RDCK to 1/2 period by flip-flop 22 and AND gate 21, if a wrong inversion occurs in the demodulation clock DMCK due to noise or some other cause, all the subsequent demodulated data S20 is wrong.

WO-A-85/01402 describes a synchronisation pattern encoding system for data sectors written on a storage medium. The system generates a unique sync pattern that is appended to a selected data sector of a disc storage system. The sync pattern is generated by encoding a prescribed data word and introducing an error during encoding so that the sync pattern does not correspond to a valid sequence of data.

This invention aims to ameliorate some of the above-discussed problems.

In accordance with this invention there is provided a data demodulation apparatus for demodulating a signal which includes coded data signal portions using a demodulation clock the signal further includes a signal portion comprising a predetermined signal pattern, characterized in that the signal is demodulated using a plurality of mutually phase-shifted demodulation clock signals, each providing a demodulation version of the signal, the correct demodulation pattern of the predetermined signal pattern producing a known demodulation pattern and there being provided means for comparing the demodulated versions of the predetermined signal pattern obtained using the different clock signals with said known demodulation pattern to determine which of the demodulating clock signals is producing the correct demodulation of the coded data signal portions.

Preferably the signal to be demodulated is divided into signal blocks, each including coded data signal portions and one predetermined signal pattern. The comparing means then compares the demodulated versions of the signal pattern of that block with the known demodulation pattern to determine which of the demodulating clock signals will produce the correct demodulation of the coded data signal portions of that block.

Preferably first and second demodulation means are provided for demodulating the signal using first and second said demodulating clock signals respectively. A signal selection means is coupled to receive the demodulated signals from the first and second demodulation means and controlled in accordance with the output of the comparing means to select the correctly demodulated signal for output from the system.

The present invention will be more fully understood from the detailed description given hereinbelow and the accompanying drawings which are given by way of illustration only, and thus are not limitative of the present invention and wherein:

Fig. 1 is a block diagram of a system configuration for performing the demodulation system according to this invention;

Fig. 2 is an explanatory diagram to show the coding type of the 2-7 modulation/demodulation system;

Fig. 3 is a circuit diagram of a conventional demodulation circuit;

Fig. 4 is an explanatory diagram of a recording format in recording medium; and

Fig. 5 and Fig. 6 are explanatory diagrams of bit patterns.

Referring now to the drawings, this invention is described herein in details, specifically relating to some of its embodiments.

Fig. 4 shows an example of the recording format employed in magnetic recording, optical recording, etc. Fig. 1 is a block diagram of the system configuration for the demodulation system of this invention. The tracks on the recording medium are, for example, divided into $n_1$ sectors as shown in Fig. 4(a).

A drive unit (DU) 100 in Fig. 1 writes data in the units of these sectors. Each sector is composed of, a control signal area comprising ID, SYNC, etc., shown in Fig 4(b), and a user data recording area comprising $n_2$ blocks. Each block is composed of $n_3$ bytes as shown in Fig. 4(c). At the beginning or at the end of this block, a resynchronisation signal is added composed of a specified data bit pattern and a code bit pattern.

The above specified data bit pattern and code bit pattern are briefly described below.

The data bit pattern is a bit pattern before modulation. It comprises a row of consecutive data, for example a data row as shown in Fig. 5(a). When this bit pattern is 2-7 modulated, as shown in Fig. 5(b), as the word length of the 2-7 modulation/demodulation system is variable, a bit pattern that cannot be modulated using the 2-7 conversion rule may occur at the end of a data row or at the dividing portion of block. Accordingly, a specified data bit pattern is added in order to satisfy the 2-7 conversion rule to ensure that the entire data of a block or row can be modulated. One example of a suitable specified data bit pattern for application to the end of a data row or block is shown in Fig. 5(c).

The specified code bit pattern is a bit pattern after modulation. It is used in the detection of the beginning of a block during demodulating. In order to enhance the reliability of demodulation, a pattern not produced as a result of modulation using the 2-7 conversion code, such as the code bit pattern shown in Fig. 6(a) is preferable. Part (1) of the pattern of Fig. 6(a) is the same as the pattern after modulation of the specified data bit pattern shown in Fig. 5(c). By adding part (2) of Fig. 6(a) to this data row, a pattern which is not produced by modulation using the 2-7 conversion rule is obtained. When the pattern of Fig. 6(a) is demodulated, the result is always the pattern of Fig. 6(b).

In the system shown in Fig. 1, the data being read out by the drive unit (DU) 100 for recording and reproducing data is synchronised by a PLL circuit 200, from which read data RDDT and read clock RDCK are delivered. The RDDT and RDCK signals are fed into a pattern detector circuit 10 composed of a shift register, a pattern discriminator, and a 2-7 demodulation circuit 23. The pattern detector circuit 10 discriminates the RDDT, and detects the specified code bit pattern and SYNC pattern, and delivers a detection signal to the comparator 17. The RDDT fed into the 2-7 demodulation circuit 23 is converted into parallel by the shift register 11, and is assembled by a gate group 12 to be returned to serial data S23. the read clock RDCK is directly divided into RDCK and $\overline{RDCK}$ through NOT circuit 24, which are respectively fed into demodulation clock generator circuits 15, 16, to generate demodulation clock signals DMCK1, DMCK2. DMCK1 and DMCK2 are respectively fed into flip-flops (FF) 13, 14. In the flip-flops (FF) 13, 14, the serial data S23 is synchronised for conversion back into data before modulation. As the data is demodulated in the flip-flops (FF) 13, 14 by demodulation clocks DMCK1, DMCK2 differing in phase, the data output from the respective flip-flops (FF) is different. Only one of the outputs corresponds to the original data before modulation.

The outputs of the flip-flops (FF) 13, 14 are fed into a comparator 17, which receives the detection signal of a specified code bit pattern shown in Fig. 6(a) from the pattern detector circuit 10. The outputs of the flip-flops (FF) 13, 14 are compared with the bit pattern of Fig. 6(b) on receipt of the detection signal, and a judgement signal is delivered to a multiplexer (MPX) 18 depending on which output of the flip-flops (FF) 13, 14 corresponds to the bit pattern of Fig. 6(b). The multiplexer (MPX) 18 receives this judgement signal, and selects which output corresponds to the correctly demodulated data signal each time the signal of Fig. 6(a) is detected to ensure that a signal corresponding to the original data signal is delivered to the shift register 19.

The present invention can thereby keep the spread of error in the demodulated data to a minimum when an incorrect inversion occurs in the read clock RDCK. Besides, as shown in Fig. 1, having two demodulation clock generator circuits 15, 16 and hence a normal demodulation clock DMCK1 and an inverted demodulation clock DMCK2, if an incorrect inversion occurs in the normal demodulation clock DMCK1, the next time the signal of Figure 6(a) is detected, the multiplexer (MPX) 17 selects the other demodulation clock DMCK2 for demodulation of the signal, so that any error in demodulation is limited to a single block, allowing normal demodulation of subsequent blocks.

As is clear from the description above, through the use of two demodulation clocks differing in phase, even if an incorrect inversion occurs in the read demodulation clock due to skipping, overflow or some other cause during the demodulation of any one block, normal operation is restored for demodulation of the next block. The reliability of the demodulated data is thereby enhanced. In order to operate securely, it is important to detect the beginning portion of a block. In this invention, by using a pattern not produced by modulation of a signal using the 2-7 conversion code, that is, by using a pattern which is not produced in the coded data, the beginning of a block can be detected without fail. Incidentally, the pattern of Fig. 6 (a) may be also used as the bit pattern of SYNC information.

**Claims**

1. A data demodulation apparatus for demodulating a signal which includes coded data signal portions using a demodulation clock, the signal further including a signal portion comprising a predetermined signal pattern (Fig. 6a), characterized in that the signal is demodulated using a plurality of mutually phase-shifted demodulation clock signals (DMCK1, DMCK2), each providing a demodulation version of the signal, the correct demodulation pattern of the predetermined signal pattern producing a known demodulation pattern (Fig 6b) and there being provided means (17) for comparing the demodulated versions of the predetermined signal pattern obtained using the different clock signals with said known demodulation pattern to determine which of the demodulating clock signals is producing the correct demodulation of the coded data signal portions.

2. A data demodulation apparatus according to claim 1 wherein the signal to be demodulated is divided into signal blocks, each including coded data signal portions and one said predetermined signal pattern (Fig. 6a), and wherein said comparing means is operable for each signal block to compare said demodulated versions of the signal pattern of that block with said known demodulation pattern and to determine which of the demodulating clock signals will produce correct demodulation of the coded data signal portions of that block.

3. A data demodulation apparatus according to claim 1 or claim 2 characterized in that there are provided first and second demodulation means (13, 14) for demodulating the signal using first and second said demodulating clock signals respectively, and in that a signal selection means (18) is coupled to receive the demodulated signals from said first and second demodulation means and controlled in accordance with the output of said comparing means (17) to select that one of said demodulated signals which is correctly demodulated, for output from the apparatus.

4. A data demodulation apparatus according to any of claims 1 to 3 characterised in that said predetermined signal pattern (Fig. 6a) is a pattern which cannot be produced by the encoding apparatus used to produce said coded data signal portions.

**Revendications**

1. Un appareil de démodulation de données pour démoduler un signal qui comprend des parties de signal à données codées en utilisant un signal d'horloge de démodulation, le signal incluant en outre une partie de signal comprenant une configuration prédéterminée de signal (Fig. 6a) caractérisé en ce que le signal est démodulé en utilisant plusieurs signaux d'horloge de démodulation déphasés entre eux (DMCK1, DMCK2), chacun fournissant une version de démodulation du signal, la configuration correcte de démodulation de la configuration prédéterminée de signal produisant une configuration connue de démodulation (Fig. 6b) et des moyens (17) étant prévus pour comparer, avec ladite configuration connue de démodulation, les versions démodulées de la configuration prédéterminée de signal obtenues en utilisant les différents signaux d'horloge pour déterminer celui des signaux d'horloge de démodulation qui produit la démodulation correcte des parties de signal à données codées.

2. Un appareil de démodulation de données selon la revendication 1 dans lequel le signal à démoduler est divisé en blocs de signal, chacun incluant des parties de signal à données codées et une dite configuration prédéterminée de signal (Fig. 6a), et dans lequel ledit moyen de comparaison peut fonctionner pour chaque bloc de signal afin de comparer lesdites versions démodulées de la configuration de signal de ce bloc avec ladite configuration connue de démodulation et de déterminer celui des signaux d'horloge de démodulation qui produira une démodulation correcte des parties de signal à données codées de ce bloc.

3. Un appareil de démodulation de données selon la revendication 1 ou la revendication 2 caractérisé en ce qu'il est prévu un premier et un deuxième moyens de démodulation (13, 14) pour démoduler le signal en utilisant un premier et un deuxième desdits signaux d'horloge de démodulation respectivement, et en ce qu'un moyen (18) de choix de signal est couplé pour recevoir les signaux démodulés depuis lesdits premier et deuxième moyens de démodulation et réglé conformément à la sortie dudit moyen (17) de comparaison pour choisir comme sortie de l'appareil celui desdits signaux démodulés qui est correctement démodulé.

4. Un appareil de démodulation de données selon l'une quelconque des revendications 1 à 3 caractérisé en ce que ladite configuration prédéterminée de signal (Fig. 6a) est une configuration qui ne peut pas être produite par l'appareil d'encodage utilisé pour produire lesdites parties de signal à données codées.

**Patentansprüche**

1. Vorrichtung zur Datendemodulation zur Demodulation eines Signals, welches kodierte Datensignalteile enthält, unter Verwendung einer Demodulationsuhr, wobei das Signal weiterhin ein Signalteil mit einem vorbestimmten Signalmuster (Fig. 6a) beinhaltet, **dadurch gekennzeichnet**, daß das Signal unter Verwendung einer Anzahl von gegenseitig phasenverschobenen Demodulationsuhrsignalen (DMCK1, DMCK2) demoduliert wird, von denen jedes eine Demodulationsversion des Signals bereitstellt, wobei das korrekte Demodulationsmuster des vorbestimmten Signalmusters ein bekanntes Demodulationsmuster (Fig. 6b) erzeugt, und wobei eine Einrichtung (17) vorhanden ist zum Vergleichen der demodulierten Versionen des vorbestimmten Signalmusters, die unter Verwendung der unterschiedlichen Uhrsignale erhalten werden, mit dem bekannten Demodulationsmuster, um festzulegen, welches der demodulierten Uhrsignale die korrekte Demodulation der kodierten Datensignalteile erzeugt.

2. Vorrichtung zur Datendemodulation nach Anspruch 1, wobei das zu demoduliernde Signal in Signalblöcke unterteilt ist, wobei jeder Block kodierte Datensignalbereiche und ein vorbestimmtes Signalmuster (Fig. 6a) enthält, und wobei die Vergleichseinrichtung auf jeden Signalblock anwendbar ist, um die demodulierten Versionen der Signalmuster dieses Blocks mit dem bekannten Demodulationsmuster zu vergleichen und um festzustellen, welches der Demodulationsuhrsignale eine korrekte Demodulation der kodierten Datensignalteile des Blockes erzeugt.

3. Vorrichtung zur Datendemodulation anch Anspruch 1 oder 2, **dadurch gekennzeichnet**, daß erste und zweite Demodulationseinrichtungen (13, 14) zur Demodulation des Signals unter Verwendung von einer ersten bzw. einer zweiten Demodulationsuhr vorhanden sind, und daß eine Signalauswahleinrichtung (18) angeschlossen ist, um die demodulierten Signale von der ersten und der zweiten Demodulationseinrichtung zu empfangen und um gesteuert durch die Ausgabe der Vergleichseinrichtung (17) das korrekt demodulierte Signal zum Ausgang aus der Vorrichtung zu selektieren.

4. Vorrichtung zur Datendemodulation nach einem der Ansprüche 1 bis 3, **dadurch gekennzeichnet**, daß das vorbestimmte Signalmuster (Fig 6a) ein Muster ist, welches von dem Kodierer, der zur Erzeugung der kodierten Datensignalteile verwendet wird, nicht erzeugt werden kann.

## Fig.1.

DRIVE UNIT (DU)

200

PATTERN DETECTOR CIRCUIT

10

RDDT

RDCK

100

PLL CIRCUIT

BYTE COUNTER

BIT COUNTER

TIMING SIGNAL GENERATOR

SHIFT REGISTER

11    12    S23    13

GATE    FF

COMPARATOR

DMCK1

15    14

FF

17    18    19    SHIFT REGISTER

16    DMCK2    MPX

23

## Fig.2.

| DATA BIT | CODE BIT |
|----------|----------|
| 1 0 | 0 1 0 0 |
| 0 1 0 | 1 0 0 1 0 0 |
| 0 0 1 0 | 0 0 1 0 0 1 0 0 |
| 1 1 | 1 0 0 0 |
| 0 1 1 | 0 0 1 0 0 0 |
| 0 0 1 1 | 0 0 0 0 1 0 0 0 |
| 0 0 0 | 0 0 0 1 0 0 |

Fig.3.

EP 0 232 144 B1

## Fig.4.

FIRST SECTOR

(a) | | | 2 | 3 | 4 | 5 | ⌇ | | $n_1$ |

(b) | ID | SYNC | | 2 | 3 | 4 | ⌇ | | $n_2$ |

FIRST BLOCK

(c) | 1 | 2 | 3 | 4 | ⌇ | | | $n_3$-1 | $n_3$ |

## Fig.5.

(a) ----- 1 0 0 1 0 1 1 0 0 0 0 0 1 0 0

(b) 0100  100100  1000  00010  00001000  ?

(c) 0 1 1

## Fig.6.

(a) 0 0 1 0 0 0 0 0 0 0 1 0 0 1 0 0

(1)  (2)

(b) 0 1 1 0 0 0 1 0